# EUROPÄISCHE PATENTSCHRIFT

(11) **EP 0 510 426 B1**
(45) Veröffentlichungstag und Bekanntmachung des Hinweises auf die Patenterteilung: **07.01.1998**
(21) Anmeldenummer: 92106041.4
(22) Anmeldetag: 08.04.1992
(51) Int. Cl.: G01R 15/18, H01F 38/30

(54) **Stromwandler fur eine Mittel oder Hochspannungsanlage**
Current transformer for medium or high tension
Transformateur de courant pour moyen ou haute tension

(30) Priorität: 22.04.1991 CH 1196/91
(43) Veröffentlichungstag der Anmeldung: 28.10.1992
(73) Patentinhaber: ASEA BROWN BOVERI AG, 5400 Baden (CH)
(72) Erfinder: Haffner, Yves, CH-5400 Baden (CH); Koch, Andreas, CH-5620 Zufikon (CH); Kornfeld, Amos, Dr., CH-5213 Villnachern (CH)

(56) Entgegenhaltungen:
- EP-A- 0 165 835
- FR-A- 2 230 052
- FR-A- 2 255 603
- IEE PROCEEDINGS B. ELECTRICAL POWER APPLICATIONS Bd. 130, Nr. 5, September 1983, OLD WOKING, GB Seiten 360 - 363 J.A.J. PETTINGA ET AL. 'A POLYPHASE 500KA CURRENT MEASURING SYSTEM WITH ROGOWSKI COILS'
- MESSTECHNIK Bd. 79, Nr. 6, Juni 1971, MUENCHEN DE Seiten 127 - 134 F. LABUHN ET AL. 'STROMMESSUNGEN AN IMPULSENTLADUNGEN MIT ROGOWSKI-SPULEN'

## Beschreibung

### TECHNISCHES GEBIET

Bei der Erfindung wird ausgegangen von einem Stromwandler für eine Mittel- oder Hochspannungsanlage nach dem Oberbegriff von Patentanspruch 1.

### STAND DER TECHNIK

Ein Stromwandler der vorgenannten Art ist in EP-A-0 165 835 beschrieben. Dieser Stromwandler weist einen aus unmagnetischem Material gebildeten torusförmigen Kern von rechteckigem Querschnitt auf, durch den ein stromführender Leiter einer Mittel- oder Hochspannungsanlage geführt ist, und welcher eine nach Art einer Rogowskispule gewickelte Spule trägt. Die Spule ist in einer Abschirmung gehalten. Ein aus einem Material hoher magnetischer Permeabilität bestehendes Teil der Abschirmung umgibt die Spule und schirmt sie nach aussen ab. Ein zwischen Spule und Stromleiter angeordnetes und aus unmagnetischem Material gebildetes Teil der Abschirmung schirmt die Spule gegenüber dem Stromleiter ab. Von den Spulenanschlüssen an eine Auswerteelektronik geführte Messignale zeichnen sich durch einen geringen Rauschpegel aus.

Ein in FR-A-2 255 603 beschriebener Stromwandler für eine metallgekapselte Hochspannungsanlage enthält einen in der Metallkapselung angeordneten, ringförmig ausgebildeten Giessharzkörper, durch den ein stromführender Leiter der Anlage geführt ist, und in den drei axial gegeneinander versetzt angeordnete und vom Stromleiter durchsetzte Sekundärwicklungen eingebettet sind. Eine mittlere der drei Wicklungen ist auf einem eisenfreien, ringförmigen Kern mit rechteckigem Querschnitt angeordnet. Im Vergleich zum Radius und zur axialen Ausdehnung ist der Kern in radialer Richtung nur gering bemessen. Der Durchmesser der Metallkapselung kann so ersichtlich gering gehalten werden. Der Ausgang der mittleren Wicklung ist auf den Eingang eines von den beiden anderen Wicklungen gespeisten Operationsverstärkers einer Auswertelektronik geführt. Eine die Messgenauigkeit des Stromwandlers verbessernde Abschirmung der mittleren Wicklung weist dieser Stromwandler nicht auf.

Bei einem aus FR-A-2 230 052 ersichtlichen Stromwandler für eine metallgekapselte Hochspannungsanlage sind in der Kapselung Sekundärwicklungen tragende, ringförmige Eisenkerne von rechteckigem Querschnitt angeordnet, welche auf einem ringförmig ausgebildeten Tragkörper aus Giessharz oder aus Metall gehalten sind. Im Vergleich zum Radius und zur axialen Ausdehnung sind die Kerne in radialer Richtung nur gering bemessen. Entsprechend dem zuvor beschriebenen Stromwandler kann der Durchmesser der Metallkapselung so gering gehalten werden.

Aus IEE Proceedings, Bd.130, Nr.5, September 1983, Seiten 360-363 ist es bekannt, dass in mittel- oder hochspannungsführenden Leitern fliessende Ströme mit Hilfe von abgeschirmten Rogowskispulen potentialfrei mit guter Genauigkeit bestimmt werden können.

### KURZE DARSTELLUNG DER ERFINDUNG

Der Erfindung, wie sie in Patentanspruch 1 angegeben ist, liegt die Aufgabe zugrunde, einen Stromwandler für Mittel- oder Hochspannungsanlagen anzugeben, welcher geringe Abmessungen aufweist, und dessen Stromsensor problemlos an beliebigen Stellen in die Anlage eingebaut werden kann und sich dennoch durch eine besonders grosse Empfindlichkeit auszeichnet.

Der Stromwandler nach der Erfindung zeichnet sich bei geringem Gewicht und geringem Platzbedarf durch eine hohe Messgenauigkeit aus. Zudem weist er einen über viele Grössenordnungen erstreckten Messbereich auf sowie eine grosse Linearität in diesem Messbereich. Die guten Messeigenschaften sind zum einen eine Folge der geometrischen Gestaltung des Kerns seiner Rogowskispule, da hierdurch Unsymmetrien im Magnetfeld des zu messenden Stroms ausgeglichen werden und zugleich der Einfluss unerwünschter Fremdfelder verringert wird. Zum anderen wird durch die Verwendung von isotropem Material für den Kern der Rogowskispule und den die Spule fixierenden Isolierkörper erreicht, dass sich Kern und Isolierkörper bei Temperaturänderungen in allen Richtungen gleichmässig dehnen bzw. zusammenziehen. Die die Messgenauigkeit bestimmende Geometrie der Spule kann so durch ständige Temperaturüberwachung der Spule erfasst und eine aus dieser Überwachung resultierende ständige Anpassung der Auswerteelektronik leicht kompensiert werden.

Ein bevorzugtes Ausführungsbeispiel der Erfindung und die damit erzielbaren weiteren Vorteile werden nachfolgend anhand von Zeichnungen näher erläutert.

### KURZE BESCHREIBUNG DER ZEICHNUNGEN

In den Zeichnungen ist ein Ausführungsbeispiel der Erfindung vereinfacht dargestellt, und zwar zeigt:
- Fig.1: eine Seitenansicht einer teilweise im Schnitt dargestellten metallgekapselten, gasisolierten Mittelspannungsschaltanlage mit einem Stromwandler nach der Erfindung,
- Fig.2: eine Aufsicht auf einen im Schnitt dargestellten Teil des Stromwandlers nach Fig.1, und
- Fig.3: ein den Signalablauf im Stromwandler nach den Figuren 1 und 2 darstellendes Blockschaltbild.

### WEGE ZUR AUSFÜHRUNG DER ERFINDUNG

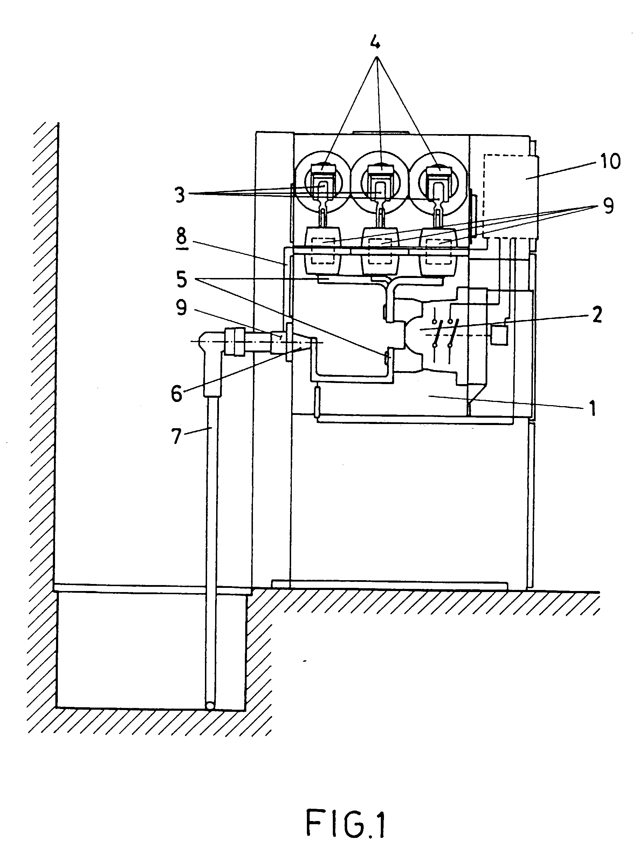

In Fig.1 ist eine metallgekapselte, gasisolierte Mittelspannungsschaltanlage dargestellt,die mit Spannungen bis zu 24 kV betrieben werden kann. Diese Anlage weist als Metallkapselung ein geschnitten dargestelltes Gehäuse 1 auf. Das Gehäuse ist mit einem Isoliergas, wie insbesondere SF₆, von bis zu einigen Bar Druck gefüllt. Im Inneren des Gehäuses sind Starkstromkomponenten, wie Leistungsschalter 2, Trennschalter 3 und Sammelschienen 4, angeordnet. Die Starkstromkomponenten sind über Stromleiter 5 phasenweise miteinander elektrisch verbunden. Über Kabeldurchführungen 6 werden die Stromleiter 5 aus dem Gehäuse 1 an Kabel 7 geführt. Die Grösse der in den Stromleitern 5 fliessenden Ströme wird von Stromwandlern 8 erfasst. Jeder der Stromwandler 8 weist einen den zugeordneten Stromleiter 5 konzentrisch umgebenden Stromsensor 9 auf sowie nicht bezeichnete Signalleitungen und eine Auswerteelektronik 10, in der die vom Stromsensor 9 erfassten und über die Signalleitungen weitergeführten Messignale ausgewertet werden.

Jeder Stromsensor 9 weist geringe Abmessungen auf und kann daher problemlos an beliebigen Stellen in die Anlage eingebaut werden. Zu bevorzugen ist eine Integration des Stromsensors 9 in die Kabeldurchführung 6, da hierdurch deren Abmessungen praktisch nicht beeinflusst werden, und da in diesem Fall die Kabeldurchführung 6 zugleich als Tragkörper des Stromsensors 9 wirkt und ein zusätzlicher Tragkörper entbehrlich ist.

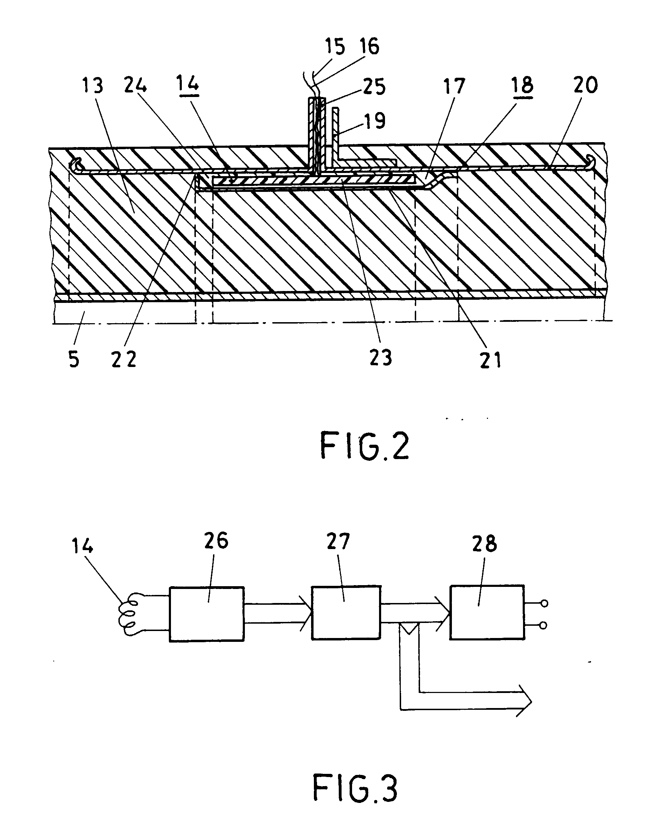

Aus Fig.2 sind Aufbau und Anordnung des Stromsensors 9 des Stromwandlers 8 zu erkennen. Der in dieser Figur vergrössert dargestellte Teil des Stromsensors 9 enthält im wesentlichen einen ringförmigen, von der Kabeldurchführung 6 gebildeten Tragkörper 13 sowie eine torusförmig gewickelte, ringförmige Spule 14 und von der Spule 14 zur Auswertelektronik 10 des Stromwandlers 8 geführte Signalleitungen 15 und 16, in welcher Auswerteelektronik 10 aus den vom Stromsensor 9 abgegebenen Signalen Messwerte gebildet werden, die dem im Stromleiter 5 fliessenden Strom entsprechen.

Der Tragkörper 13 enthält einen den Stromleiter 5 ringförmig umgebenden Raum 17, in dem die Spule 14 angeordnet ist. Der Raum 17 ist nahezu allseitig begrenzt von einer störende elektrische Felder fernhaltenden Abschirmung 18 aus elektrisch leitendem Material, wie insbesondere Aluminium oder Kupfer. Die Abschirmung 18 steht über einen Anschlusskontakt 19 mit dem Gehäuse 1 der Anlage in elektrisch leitender Verbindung und ist so auf das definierte Massepotential der Anlage gebracht. Hierdurch ist der Raum 17 elektrisch gegenüber dem Einfluss unerwünschter, etwa durch transiente Vorgänge - wie Schalthandlungen oder Blitzstösse - gebildeter Störfelder, abgeschirmt, und werden von der Spule 14 daher beim Messen in der Anlage unter Betriebsbedingungen nahezu fehlerfreie Signale abgegeben.

Die Abschirmung 18 besteht im wesentlichen aus zwei überwiegend hohlzylindrisch ausgebildeten Elektoden 20, 21, von denen die Elektrode 20 zugleich eine Steuerelektode der Kabeldurchführung 6 ist und die andere Elektrode 21 wulstartige Kontur aufweist. Beide Elektroden 20, 21 sind an einer Stirnseite der Elektrode 21 miteinander elektrisch leitend und mechanisch verbunden. An der anderen Stirnseite der Elektrode 21 sind sie unter Bildung einer den Stromleiter 5 ringförmig umgebenden Isolierstelle 22 voneinander elektrisch isoliert. Hierdurch wird der Raum 17 elektrisch abgeschirmt und wird zugleich die Ausbildung unerwünschter Wirbelströme vermieden.

Die Spule 14 ist nach Art einer Rogowskispule auf einen ringförmigen Kern 23 aus nichtferromagnetischem Material gewickelt. Der Kern 23 hat in axialer Richtung geschnitten im wesentlichen rechteckigen Querschnitt und ist im Vergleich zu seinem Radius sowie zu seiner axialen Erstreckung in radialer Richtung nur sehr gering bemessen. Bei einem Radius von beispielsweise 55 mm und einer axialen Längserstreckung von beispielsweise 30 mm weist er typischerweise eine Dicke von nur 2 mm auf. Hierdurch werden Unsymmetrien im Magnetfeld des zu messenden Stromes ausgeglichen und wird zugleich der Einfluss unerwünschter Fremdfelder minimiert. Der die Spule 14 aufnehmende Raum 17 ist mit einem ringförmigen Isolierkörper 24 ausgefüllt, durch den die Spule 14 im Raum 17 und damit auch am Tragkörper 13 fixiert ist.

Der Isolierkörper 24 und der Kern 23 der Spule 14 enthalten ein überwiegend isotropes Material. Hierdurch wird erreicht, dass sich Isolierkörper 24 und Kern 23 bei Temperaturänderungen in allen Richtungen gleichmässig dehnen bzw. zusammenziehen. Die Geometrie der Spule 14 wird daher bei Temperaturveränderungen linear verändert. Diese Änderung kann durch eine ständige Temperaturüberwachung des Stromsensors 10 und eine aus dieser Überwachung resultierende ständige Anpassung der Auswerteelektronik 10 leicht kompensiert werden.

Eine besonders hohe Messgenauigkeit lässt sich erreichen, wenn das Material des Isolierkörpers 24 und des Kerns 23 der Spule 14 einen an das Material des Tragkörpers 13 der Kabeldurchführung 6 - üblicherweise eine ausgehärtete Vergussmasse auf der Basis von Epoxidharz - bzw. der Abschirmung 18 angepassten Koeffizienten der Wärmeausdehnung aufweisen. Sehr bewährt als Material für den Isolierkörper 24 und/oder den Kern 23 hat sich eine mit Glaskügelchen gefüllte Vergussmasse, insbesondere auf der Basis eines Epoxidharzes. Als Material für den Kern 23 kann auch ein nichtferromagnetisches Metall verwendet werden. Insbesondere Aluminium ist hierfür besonders geeignet, da es bei hohen Frequenzen induzierte Spannungsspitzen stark dämpft, und da es zugleich einen dem im Isolierkörper 24 bzw. im Tragkörper 13 verwendeten Isoliermaterial entsprechenden Koeffizienten der Wärmeausdehnung aufweist.

Der Stromsensor 10 lässt sich in einfacher Weise durch Vergiessen vormontierter Teile, wie Abschirmung 18 mit Anschlusskontakt 19, Stromleiter 5 und Spule 14 mit Signalleitungen 15, 16 und einer die Signalleitungen umgebenden und mit der Abschirmung 18 kontaktierten Abschirmung 25 eines zur Auswerteelektronik geführten abgeschirmten Messkabels, mit einer nach Aushärtung zum Material des Isolierkörpers 24 sowie des Tragkörpers 13 führenden Vergussmasse fertigen. Soll der Stromsensor 9 unabhängig von der Kabeldurchführung 6 gefertigt werden, so ist es möglich, die Spule 14 in einer Form unter Bildung des Isolierkörpers 24 zu umgiessen und sodann die nach Aushärten im Isolierkörper 24 fixierte Spule 14 in die mit Montageansätzen versehene und nun zusätzlich als Tragkörper dienende Abschirmung 18 einzusetzen oder die Spule 14 unter Bildung des Isolierkörpers 24 direkt in der ebenfalls als Tragkörper 13 ausgebildeten Abschirmung 18 zu umgiessen.

Die Spule 14 liefert der zeitlichen Änderung des im Stromleiter 5 fliessenden Stromes proportionale Signale. Diese Signale sind aufgrund der geeignet angeordneten Abschirmungen 18 und 25 frei von den Einflüssen unerwünschter äusserer Fremdfelder und von in der Anlage auftretenden, transienten Vorgängen. Sie werden in der Auswerteelektronik 10 zu einem dem zu ermittelndem Strom entsprechenden Signal integriert. Wie aus Fig.3 ersichtlich ist, werden diese Signale zunächst in einem Analog- Digital- Wandler 26 digitalisiert und die digitalisierten Signale anschliessend in einer als Digitalintegrator 27 ausgebildeten Integriervorrichtung zu einem dem zu messenden Strom entsprechenden Signal integriert. Dieses Signal kann dann wahlweise in einem nachgeschalteten Digital- Analog- Wandler 28 für eine Analoganzeige umgewandelt werden und/oder zur weiteren Verarbeitung an andere Funktionseinheiten der Anlage weitergeleitet werden.

### BEZUGSZEICHENLISTE

- 1: Gehäuse
- 2: Leistungsschalter
- 3: Trennschalter
- 4: Sammelschienen
- 5: Stromleiter
- 6: Kabeldurchführung
- 7: Kabel
- 8: Stromwandler
- 9: Stromsensor
- 10: Auswerteelektronik
- 13: Tragkörper
- 14: Spule
- 15, 16: Signalleitungen
- 17: Raum
- 18: Abschirmung
- 19: Anschlusskontakt
- 20, 21: Elektroden
- 22: Isolierstelle
- 23: Kern
- 24: Isolierkörper
- 25: Abschirmung
- 26: Analog- Digital- Wandler
- 27: Digitalintegrator
- 28: Digital- Analog- Wandler

## Patentansprüche

1. Stromwandler (8) für eine Mittel- oder Hochspannungsanlage mit einem als torusförmig gewickelte Spule (14) ausgebildeten Stromsensor (9), einem der Halterung des Stromsensors (9) dienenden, ringförmigen Tragkörper (13), einem von der Spule (14) konzentrisch umgebenen Stromleiter (5), einer Auswertelektronik (10) und einem Ausgangssignale von der Spule (14) zur Auswerteelektronik führenden, abgeschirmten Messkabel, bei dem die Spule (14) nach Art einer Rogowskispule auf einen ringförmigen Kern (23) aus nichtferromagnetischem Material von in axialer Richtung geschnitten im wesentlichen rechteckigem Querschnitt gewickelt ist und in einem gegenüber elektrischen Feldern abgeschirmten, hohlzylindrisch ausgebildeten Hohlraum (17) des Tragkörpers (13) angeordnet ist, dadurch gekennzeichnet, dass der ringförmige Kern (23) im Vergleich zu seinem Radius und zu seiner axialen Erstreckung eine geringe radiale Bemessung aufweist, dass der abgeschirmte Hohlraum (17) mit einem die Spule (14) fixierenden Isolierkörper (24) ausgefüllt ist, und dass der Isolierkörper (24) und der Kern (23) der Spule (14) überwiegend isotropes Material enthalten.

2. Stromwandler nach Anspruch 1, dadurch gekennzeichnet, dass das Material des Isolierkörpers (24) und des Kerns (23) der Spule (14) einen an das Material des Tragkörpers (13) angepassten Koeffizienten der Wärmeausdehnung aufweisen.

3. Stromwandler nach einem der Ansprüche 1 oder 2, dadurch gekennzeichnet, dass zumindest der Kern (23) von einer mit kugelförmigen Teilchen gefüllten, ausgehärteten Vergussmasse aus Isoliermaterial gebildet ist.

4. Stromwandler nach Anspruch 1, dadurch gekennzeichnet, dass der Kern (23) ein nichtferromagnetisches Metall enthält.

5. Stromwandler nach Anspruch 4, dadurch gekennzeichnet, dass das nichtferromagnetische Metall Aluminium ist.

6. Stromwandler nach einem der Ansprüche 1 bis 5, dadurch gekennzeichnet, dass der Raum (17) von einer auf Massepotential der Anlage befindlichen Abschirmung (18) umgeben ist, welche in elektrisch leitender Verbindung mit der Abschirmung (25) des Messkabels steht.

7. Stromwandler nach Anspruch 6, dadurch gekennzeichnet, dass die Abschirmung (18) des Raums (17) unterbrochen ist durch eine den Stromleiter (5) ringförmig umgebende Isolierstelle (22).

8. Stromwandler nach einem der Ansprüche 6 oder 7, dadurch gekennzeichnet, dass die Abschirmung (18) des Raums (17) zwei überwiegend hohlzylindrisch ausgebildete Elektroden (20, 21) enthält, von denen die eine (20) als Steuerelektrode einer Kabeldurchführung (6) der Anlage dient.

9. Stromwandler nach einem der Ansprüche 1 bis 8, dadurch gekennzeichnet, dass die von der Spule (14) abgegebenen Signale in der Auswerteelektronik (10) auf eine als Digitalintegrator (27) ausgeführte Integriervorrichtung wirken, welcher ein Analog- Digital- Wandler (26) vor- und ein Digital-Analog- Wandler (28) nachgeschaltet ist.

## Claims

1. Current transformer (8) for a medium- or high-voltage system having a current sensor (9) which is designed as a toroidally wound coil (14), an annular supporting body (13) which is used to hold the current sensor (9), an electrical conductor (5) which is concentrically surrounded by the coil (14), evaluation electronics (10) and a screened measurement cable which carries output signals from the coil (14) to the evaluation electronics, in the case of which the coil (14) is wound like a uniform-field coil onto an annular core (23) which is made of material that is not ferromagnetic and has an essentially rectangular cross-section in the axial direction, which coil (14) is arranged in a cavity (17) in the supporting body (13) which is screened from electrical fields and is designed with a hollow-cylindrical shape, characterized in that the annular core (23) has a small radial size in comparison with its radius and with its axial extent, in that the screened cavity (17) is filled with an insulating body (24) which fixes the coil (14), and in that the insulating body (24) and the core (23) of the coil (14) predominantly contain isotropic material.

2. Current transformer according to Claim 1, characterized in that the material of the insulating body (24) and of the core (23) of the coil (14) have a coefficient of thermal expansion which is matched to that of the material of the supporting body (13).

3. Current transformer according to one of Claims 1 or 2, characterized in that at least the core (23) is formed by a cured potting compound which is filled with spherical particles and is made of insulating material.

4. Current transformer according to Claim 1, characterized in that the core (23) contains a metal which is not ferromagnetic.

5. Current transformer according to Claim 4, characterized in that the metal which is not ferromagnetic is aluminium.

6. Current transformer according to one of Claims 1 to 5, characterized in that the space (17) is surrounded by a screen (18) which is at the system earth potential and is electrically conductively connected to the screen (25) of the measurement cable.

7. Current transformer according to Claim 6, characterized in that the screen (18) of the space (17) is interrupted by an isolation point (22) which surrounds the electrical conductor (5) in an annular shape.

8. Current transformer according to one of Claims 6 or 7, characterized in that the screen (18) of the space (17) contains two electrodes (20, 21) which are designed to be predominantly hollow-cylindrical and one (20) of which is used as the control electrode of a cable bushing (6) of the system.

9. Current transformer according to one of Claims 1 to 8, characterized in that the signals emitted from the coil (14) act in the evaluation electronics (10) on an integration apparatus which is designed as a digital integrator (27), is connected upstream of an analogue/digital converter (26) and is connected downstream of a digital/analogue converter (28).

## Revendications

1. Convertisseur de courant (8) pour une installation à moyenne ou à haute tension avec un capteur de courant (9) sous la forme d'une bobine (14) enroulée selon une forme toroïdale, un support (13) de forme annulaire servant à la fixation du capteur de courant (9), un conducteur électrique (5) entouré concentriquement par la bobine (14), une électronique de traitement (10) et un câble de mesure blindé menant des signaux de sortie de la bobine (14) vers l'électronique de traitement (10), dont la bobine (14) est enroulée à la manière d'une bobine de Rogowski sur un noyau (23) de forme annulaire en matériau non ferromagnétique de section transversale essentiellement rectangulaire dans une coupe selon la direction axiale et qui est disposée dans un espace creux (17) du support (13) de forme cylindrique creuse, blindé vis-à-vis des champs électriques, caractérisé en ce que le noyau (23) de forme annulaire présente une dimension radiale faible en comparaison de son rayon et de son extension axiale, en ce que l'espace creux (17) est rempli par un isolant (24) fixant la bobine (14), et en ce que l'isolant (24) et le noyau (23) de la bobine (14) contiennent essentiellement un matériau isotrope.

2. Convertisseur de courant selon la revendication 1, caractérisé en ce que le matériau de l'isolant (24) et du noyau (23) de la bobine (14) présentent un coefficient de dilatation thermique adapté au matériau du support (13).

3. Convertisseur de courant selon l'une des revendications 1 ou 2, caractérisé en ce que le noyau (23) au moins est constitué d'une masse coulante durcie remplie de particules en forme de billes.

4. Convertisseur de courant selon la revendication 1, caractérisé en ce que le noyau (23) contient un métal non ferromagnétique.

5. Convertisseur de courant selon la revendication 4, caractérisé en ce que le métal non ferromagnétique est de l'aluminium.

6. Convertisseur de courant selon l'une des revendications 1 à 5, caractérisé en ce que l'espace (17) est entouré par un blindage (18) se trouvant au potentiel de la masse qui se trouve en liaison électriquement conductrice avec le blindage (25) du câble de mesure.

7. Convertisseur de courant selon la revendication 6, caractérisé en ce que le blindage (18) de l'espace (17) est interrompu par une zone isolante (22) entourant le conducteur électrique (5) selon une forme annulaire.

8. Convertisseur de courant selon l'une des revendications 6 ou 7, caractérisé en ce que le blindage (18) de l'espace (17) contient deux électrodes (20, 21) en forme essentiellement de cylindre creux, dont l'une (20) sert d'électrode de commande pour un passage de câble (6) de l'installation.

9. Convertisseur de courant selon l'une des revendications 1 à 8, caractérisé en ce que les signaux fournis par la bobine (14) agissent dans l'électronique de traitement (10) sur un dispositif d'intégration réalisé sous la forme d'un intégrateur numérique (27) qui est connecté en amont d'un convertisseur analogique-numérique (26) et en aval d'un convertisseur numérique-analogique (28).
